# EUROPEAN PATENT SPECIFICATION

(11) **EP 3 380 650 B1**
(45) Date of publication and mention of the grant of the patent: **30.10.2019**
(21) Application number: 16801787.9
(22) Date of filing: 28.11.2016
(51) Int. Cl.: C23C 18/44, H01L 21/288, H05K 3/24

(54) **PLATING BATH COMPOSITION AND METHOD FOR ELECTROLESS PLATING OF PALLADIUM**
PLATTIERBADZUSAMMENSETZUNG UND VERFAHREN ZUM STROMLOSEN PLATTIEREN VON PALLADIUM
COMPOSITION DE BAIN DE PLACAGE ET PROCÉDÉ POUR DÉPÔT AUTOCATALYTIQUE DE PALLADIUM

(30) Priority: 27.11.2015 EP 15196815
(43) Date of publication of application: 03.10.2018
(73) Proprietor: Atotech Deutschland GmbH, 10553 Berlin (DE)
(72) Inventor: WALTER, Andreas, 10553 Berlin (DE); SUCHENTRUNK, Christof, 10553 Berlin (DE); BECK, Thomas, 10553 Berlin (DE); STEINBERGER, Gerhard, 10553 Berlin (DE); BERA, Holger, 10553 Berlin (DE); BRUNNER, Heiko, 10553 Berlin (DE); RÜCKBROD, Sven, 10553 Berlin (DE)
(86) International application number: PCT/EP2016/079002
(87) International publication number: WO 2017/089608

(56) References cited:
- EP-A1- 2 784 182
- WO-A1-2015/155173
- US-A- 3 622 367
- US-A1- 2015 056 378

## Description

### Field of the Invention

The present invention relates to aqueous plating bath compositions and methods for electroless plating of palladium in the manufacture of printed circuit boards, IC substrates and for metallization of semiconductor wafers.

### Background of the Invention

Electroless deposition of palladium in the manufacture of printed circuit boards, IC substrates and the like as well as metallization of semiconductor wafers is an established technique. The palladium layers are used for example as barrier layers and/or wire-bondable and solderable finishes.

Electroless palladium plating bath compositions comprising a source for palladium ions, a nitrogenated complexing agent and a reducing agent selected from formic acid and derivatives thereof are disclosed in US 5,882,736. Such electroless palladium plating bath compositions are suited to deposit pure palladium in contrast to plating bath compositions containing hypophosphite as reducing agent which result in palladium-phosphorous alloy layers.

The stability of plating bath compositions comprising palladium ions is an important feature of such plating bath compositions due to the high price of palladium and the requirement for palladium layers deposited having predictable properties such as internal stress, and a high adhesion to the underlying substrate whereon the palladium layer is deposited.

The stability of such a plating bath means that the plating bath is stable against decomposition, i.e. the undesired precipitation of metallic palladium in the plating bath itself. Accordingly, a stable plating bath has a longer life time than an unstable plating bath. At the same time, the deposition rate of palladium from such a plating bath should be high enough to fulfill the requirements for an industrial palladium plating method. Thus, there is still a need for stabilising electroless palladium plating baths while keeping the deposition rate at satisfying values.

### Objective of the present Invention

It is an objective of the invention to provide a plating bath composition and a method for electroless plating of palladium wherein the plating bath stability against undesired decomposition is increased. It is a further objective of the invention to provide a plating bath composition and a method for electroless plating of palladium which allow for keeping the deposition rate at the desired satisfying value. It is a further objective of the invention to provide a plating bath composition and a method for electroless plating of palladium which allow for increasing the life time of the plating bath.

### Summary of the Invention

These objectives are solved with an aqueous plating bath composition for electroless deposition of palladium, comprising
(i) at least one source for palladium ions,
(ii) at least one reducing agent for palladium ions, and
(iii) at least one cyanide group containing aromatic compound selected from compounds according to Formula (I), salts thereof, and mixtures of the aforementioned; and/or at least one cyanide group containing aromatic compound selected from compounds according to Formula (II), salts thereof, and mixtures of the aforementioned; 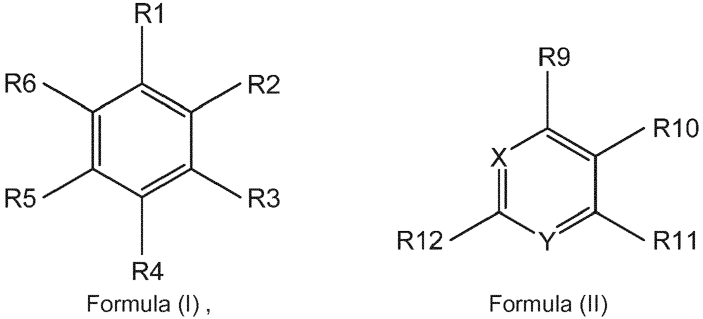
wherein R1, R2, R3, R4, R5, R6 are selected independently of each other from the group consisting of R7, -H, C1 to C6 alkyl group, C1 to C6 alkoxy group, amino, aldehyde, mercapto, sulfide group, halogen, allyl, vinyl, ethynyl, propynyl, 1-butynyl, 2-butynyl, 2-ethynylbenzene, phenyl, pyridyl, and naphthyl groups; wherein at least one of R1 to R6 is R7; wherein R7 is a moiety according to Formula (III), 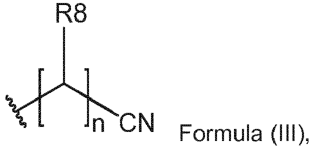
wherein each R8 is selected independently from the group consisting of -H, C1 to C6 alkyl group, hydroxyl, C1 to C6 alkoxy group, amino, mercapto, and sulfide group; wherein n is an integer ranging from 0 to 4; and
wherein X is selected from N and C-R13;
wherein Y is selected from N and C-R14; wherein at least one of X or Y is N; wherein R9, R10, R11, R12, R13, R14 are selected independently of each other from the group consisting of R15, -H, C1 to C6 alkyl group, hydroxyl, C1 to C6 alkoxy group, amino, aldehyde, carboxyl, ester, sulfonic acid, mercapto, sulfide group, halogen, allyl, vinyl, ethynyl, propynyl, 1-butynyl, 2-butynyl, 2-ethynylbenzene, phenyl, pyridyl, and naphthyl groups; wherein at least one of R9 to R14 is R15;
wherein R15 is a moiety according to Formula (IV), 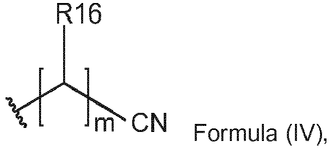
   wherein each R16 is selected independently from the group consisting of -H, C1 to C6 alkyl group, hydroxyl, C1 to C6 alkoxy group, amino, mercapto, and sulfide group; wherein m is an integer ranging from 0 to 4, and
   wherein, if at least one of X or Y is N, R15 is in the ortho or meta position in relation to N within the aromatic ring according to Formula (II).

These objectives are further solved by a method for electroless palladium plating comprising the steps of
(a) providing a substrate,
(b) contacting the substrate with the aqueous plating bath composition as described above and thereby depositing a layer of palladium onto at least a portion of the substrate.

The aqueous plating bath composition according to the invention is called the composition or the composition according to the invention herein. The terms "plating" and "depositing" are used interchangeably herein.

The cyanide group containing aromatic compounds according to Formula (I) and/or Formula (II) provide the aqueous plating bath composition according to the invention with an improved stability against undesired decomposition and a prolonged life time. Thus, the cyanide group containing aromatic compounds according to Formula (I) and/or Formula (II) act as stabilizing agents in the aqueous plating bath composition for electroless deposition of palladium. Further the cyanide group containing aromatic compounds according to Formula (I) and/or Formula (II) provide the aqueous plating bath composition according to the invention with decreased sensitivity to contaminations. Furthermore, the stable performance of the aqueous plating bath composition in the method for electroless palladium plating allows deposition of palladium layers having desired physical properties over an extended period of time. In addition, adding the cyanide group containing aromatic compounds according to Formula (I) and/or Formula (II) to an electroless palladium plating bath allows for keeping the deposition rate at satisfying values over the bath life time.

### Brief Description of the Figures

- Figure **1**: shows the deposition rate of aqueous plating bath compositions containing 3-chlorobenzonitrile or 4-amino-2-chlorobenzonitrile.
- Figure **2**: shows the deposition rate of an aqueous plating bath composition containing 2-hydroxy-2-(pyridine-3-yl)acetonitrile.
- Figure **3**: shows the deposition rate of an aqueous plating bath composition containing 2-amino-2-(pyridine-3-yl)acetonitrile.
- Figure **4**: shows the pH development of an aqueous plating bath composition containing cyanide group containing aromatic compounds according to the invention and lacking such compounds.

### Detailed Description of the Invention

The aqueous plating bath composition according to the invention comprises (iii) at least one cyanide group containing aromatic compound selected from compounds according to Formula (I), salts thereof, and mixtures of the aforementioned; and/or at least one cyanide group containing aromatic compound selected from compounds according to Formula (II), salts thereof, and mixtures of the aforementioned; 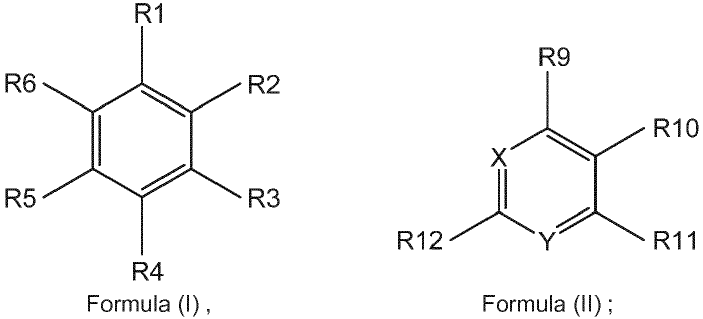 wherein R1, R2, R3, R4, R5, R6 are selected independently of each other from the group consisting of R7, -H, C1 to C6 alkyl group, C1 to C6 alkoxy group, amino, aldehyde, mercapto, sulfide group, halogen, allyl, vinyl, ethynyl, propynyl, 1-butynyl, 2-butynyl, 2-ethynylbenzene, phenyl, pyridyl, and naphthyl groups; wherein at least one of R1 to R6 is R7;
wherein R7 is a moiety according to Formula (III), 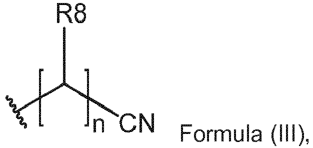
wherein each R8 is selected independently from the group consisting of -H, C1 to C6 alkyl group, hydroxyl, C1 to C6 alkoxy group, amino, mercapto, and sulfide group; wherein n is an integer ranging from 0 to 4; and
wherein X is selected from N and C-R13;
wherein Y is selected from N and C-R14; wherein at least one of X or Y is N;
wherein R9, R10, R11, R12, R13, R14 are selected independently of each other from the group consisting of R15, -H, C1 to C6 alkyl group, hydroxyl, C1 to C6 alkoxy group, amino, aldehyde, carboxyl, ester, sulfonic acid, mercapto, sulfide group, halogen, allyl, vinyl, ethynyl, propynyl, 1-butynyl, 2-butynyl, 2-ethynylbenzene, phenyl, pyridyl, and naphthyl groups; wherein at least one of R9 to R14 is R15;
wherein R15 is a moiety according to Formula (IV), 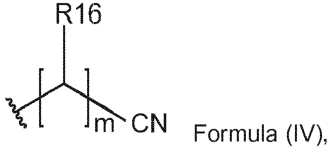
   wherein each R16 is selected independently from the group consisting of -H, C1 to C6 alkyl group, hydroxyl, C1 to C6 alkoxy group, amino, mercapto, and sulfide group; wherein m is an integer ranging from 0 to 4, and
   wherein, if at least one of X or Y is N, R15 is in the ortho or meta position in relation to N within the aromatic ring according to Formula (II).

The term "cyanide" and the chemical formula "-CN" mean herein preferably a chemical group having the structure of -C≡N. They do preferably not mean an isocyanide group, i.e. a chemical group having the structure of -N⁺≡C⁻.

Formula (I) contains R7 which is a moiety according to Formula (III). The moiety according to Formula (III) may contain the group -CHR8- . The group -CHR8- may occur n times within the moiety. Thus, R8 is present n times in the moiety, wherein n is an integer ranging from 0 to 4. Preferably, n is selected from 0, 1, 2, 3, and 4.

As R8 is present n times in the moiety, R8 is selected n times independently from the group consisting of -H, C1 to C6 alkyl group, hydroxyl, C1 to C6 alkoxy group, amino, mercapto, and sulfide group. If n is 0 (zero), R8 is not present in the moiety and is therefore not to be selected. If n is 1, R8 is present once in the moiety and is selected from the group consisting of -H, C1 to C6 alkyl group, hydroxyl, C1 to C6 alkoxy group, amino, mercapto, and sulfide group. If n > 1, R8 is present more than once in the moiety and each R8 is selected independently from the group as mentioned above. If n ranges from 2 to 4, R8 is present 2 to 4 times in the moiety and is selected 2 to 4 times independently from the group as mentioned above. In other words, each of the 2 to 4 groups R8 are selected independently of each other from the group consisting of - H, C1 to C6 alkyl group, hydroxyl, C1 to C6 alkoxy group, amino, mercapto, and sulfide group. The analogous applies for further preferred ranges of n that are defined below.

Formula (II) contains R15 which is a moiety according to Formula (IV). The moiety according to Formula (IV) may contain the group -CHR16- . The group -CHR16- may occur m times within the moiety. Thus, also R16 is present m times in the moiety according to Formula (IV), wherein m is an integer ranging from 0 to 4. Preferably, m is selected from 0, 1, 2, 3, and 4.

As R16 is present m times in the moiety according to Formula (IV), R16 is selected m times independently from the group consisting of -H, C1 to C6 alkyl group, hydroxyl, C1 to C6 alkoxy group, amino, mercapto, and sulfide group. If m is 0 (zero), R16 is not present in the moiety according to Formula (IV) and is therefore not to be selected. If m is 1, R16 is present once in the moiety according to Formula (IV) and is selected from the group consisting of -H, C1 to C6 alkyl group, hydroxyl, C1 to C6 alkoxy group, amino, mercapto, and sulfide group. If m > 1, R16 is present more than once in the moiety and each R16 is selected independently from the group as mentioned above. If m ranges from 2 to 4, R16 is present 2 to 4 times in the moiety according to Formula (IV) and is selected 2 to 4 times independently from the group as mentioned above. In other words, each of the 2 to 4 groups R16 are selected independently of each other from the group consisting of -H, C1 to C6 alkyl group, hydroxyl, C1 to C6 alkoxy group, amino, mercapto, and sulfide group. The analogous applies for further preferred ranges of m that are defined below.

Preferably, in Formula (I) at least one of R1 to R6 is halogen.

More preferably, in Formula (I) at least one of R1 to R6 is halogen and at least one of R1 to R6 is amino.

Even more preferably, in Formula (I) R1 to R6 are consisting of at least one R7, at least one halogen and at least one amino group, wherein R7 is preferably -CN.

Preferably, in Formula (I) R1, R2, R3, R4, R5, R6 are selected independently of each other from the group consisting of R7, -H, C1 to C6 alkyl group, C1 to C6 alkoxy group, amino, aldehyde, mercapto, sulfide group, halogen, allyl, vinyl, ethynyl, propynyl, 1-butynyl, 2-butynyl, 2-ethynylbenzene, phenyl, pyridyl, and naphthyl groups, wherein at least one of R1 to R6 is R7; more preferably R7, -H, C1 to C6 alkyl group, hydroxyl, C1 to C6 alkoxy group, amino, aldehyde, ester, mercapto, sulfide group, halogen, allyl, vinyl, ethynyl, propynyl, 1-butynyl, 2-butynyl, 2-ethynylbenzene, phenyl, pyridyl, and naphthyl groups, wherein at least one of R1 to R6 is R7; even more preferably R7, -H, C1 to C6 alkyl group, C1 to C6 alkoxy group, amino, aldehyde, mercapto, sulfide group, halogen, allyl, vinyl, ethynyl, propynyl, 1-butynyl, 2-butynyl, 2-ethynylbenzene, phenyl, pyridyl, and naphthyl groups, wherein at least one of R1 to R6 is R7; even more preferably R7, -H, C1 to C6 alkyl group, hydroxyl, C1 to C6 alkoxy group, amino, mercapto, sulfide group, and halogen, wherein at least one of R1 to R6 is R7; most preferably R7, -H, C1 to C6 alkyl group, C1 to C6 alkoxy group, amino, mercapto, sulfide group, and halogen, wherein at least one of R1 to R6 is R7.

Preferably, in Formula (II) R9, R10, R11, R12, R13, R14 are selected independently of each other from the group consisting of R15, -H, C1 to C6 alkyl group, hydroxyl, C1 to C6 alkoxy group, amino, aldehyde, carboxyl, ester, sulfonic acid, mercapto, sulfide group, halogen, allyl, vinyl, ethynyl, propynyl, 1-butynyl, 2-butynyl, 2-ethynylbenzene, phenyl, pyridyl, and naphthyl groups, wherein at least one of R9 to R14 is R15; more preferably R15, -H, C1 to C6 alkyl group, C1 to C6 alkoxy group, amino, aldehyde, mercapto, sulfide group, halogen, allyl, vinyl, ethynyl, propynyl, 1-butynyl, 2-butynyl, 2-ethynylbenzene, phenyl, pyridyl, and naphthyl groups, wherein at least one of R9 to R14 is R15; more preferably R15, -H, C1 to C6 alkyl group, C1 to C6 alkoxy group, amino, aldehyde, mercapto, sulfide group, halogen, wherein at least one of R9 to R14 is R15.

Preferably, the alkyl groups of R1, R2, R3, R4, R5, R6, R8, R9, R10, R11, R12, R13, R14, R16 are selected independently of each other from methyl, ethyl, n-propyl, iso-propyl, n-butyl, iso-butyl, sec-butyl, tert-butyl, pentyl or hexyl groups; more preferably from C1 to C4 alkyl groups; even more preferably from methyl, ethyl, n-propyl, iso-propyl, n-butyl, iso-butyl, sec-butyl or tert-butyl groups; further more preferably from methyl or ethyl groups.

Preferably, the alkoxy groups of R1, R2, R3, R4, R5, R6, R8, R9, R10, R11, R12, R13, R14, R16 are selected independently of each other from methoxy, ethoxy, propoxy, butoxy, pentoxy or hexoxy groups; more preferably from C1 to C4 alkoxy groups; even more preferably from methoxy, ethoxy, propoxy or butoxy groups; further more preferably from methoxy or ethoxy groups.

Preferably, the amino groups of R1, R2, R3, R4, R5, R6, R8, R9, R10, R11, R12, R13, R14, R16 are selected independently of each other from -NH₂, -NH(R17),-N(R17)(R18), wherein R17 and R18 are selected independently of each other from methyl, ethyl, n-propyl and iso-propyl. More preferably, the amino groups of R1, R2, R3, R4, R5, R6, R8, R9, R10, R11, R12, R13, R14, R16 are selected independently of each other from -NH₂, -NHCH₃, -N(CH₃)₂, -NHC₂H₅ or -N(C₂H₅)₂.

Preferably, the halogen of R1, R2, R3, R4, R5, R6, R9, R10, R11, R12, R13, R14 are selected independently of each other from fluorine, chlorine, bromine and iodine, more preferably from chlorine and bromine.

A mercapto group is the group -SH.

Preferably, the sulfide groups of R1, R2, R3, R4, R5, R6, R8, R9, R10, R11, R12, R13, R14, R16 are selected independently of each other from -SR19, wherein R19 is selected from methyl, ethyl, n-propyl and iso-propyl. More preferably, the sulfide groups of R1, R2, R3, R4, R5, R6, R8, R9, R10, R11, R12, R13, R14, R16 are selected independently of each other from -SCH₃ or -SC₂H₅.

Preferably, n and m are integers selected independently from 0, 1, 2, 3 and 4; more preferably ranging from 0 to 2; even more preferably selected from 0, 1 and 2; further more preferably ranging from 0 to 1. Most preferably, n is 0. Most preferably, m is 1.

In Formula (I) preferably, 1, 2, 3, 4, 5 or 6 of R1 to R6 are R7; more preferably 1, 2, 3, or 4 of R1 to R6 are R7; even more preferably 1 or 2 of R1 to R6 are R7; most preferably one of R1 to R6 is R7. In Formula (II) preferably, 1, 2, 3, 4, 5 or 6 of R9 to R14 are R15; more preferably 1, 2, 3, or 4 of R9 to R14 are R15; even more preferably 1 or 2 of R9 to R14 are R15; most preferably one of R9 to R14 is R15.

In Formula (II) preferably, X is selected from N and C-R13; and Y is selected from N and C-R14; and X is not N if Y is N; or Y is not N if X is N.

In Formula (II), if at least one of X or Y is N, R15 is in the ortho or meta position in relation to N within the aromatic ring according to Formula (II). More preferably, when X is not N if Y is N, or when Y is not N if X is N, R15 is in meta position in relation to N within the aromatic ring according to Formula (II).

In Formula (II) preferably, R9 to R14 are consisting of at least one R15, wherein R15 is preferably selected from -CH(CN)OH and -CH(CN)NH₂.

In one embodiment, the aqueous plating bath composition according to the invention comprises (iii) at least one cyanide group containing aromatic compound selected from compounds according to Formula (I) and/or Formula (II), salts thereof, and mixtures of the aforementioned,
wherein R1, R2, R3, R4, R5, R6 are selected independently of each other from the group consisting of R7, -H, C1 to C4 alkyl group, C1 to C4 alkoxy group, amino, mercapto, sulfide group, halogen; and
wherein 1 or 2 of R1 to R6 are R7; and wherein each R8 is selected independently from the group consisting of -H, methyl, ethyl, hydroxyl, methoxy, ethoxy, amino, mercapto, and sulfide group; wherein n is an integer ranging from 0 to 2; and
wherein R9, R10, R11, R12, R13, R14 are selected independently of each other from the group consisting of R15, -H, C1 to C4 alkyl group, C1 to C4 alkoxy group, amino, mercapto, sulfide group, halogen; and wherein 1 or 2 of R9 to R14 are R15; and wherein each R16 is selected independently from the group consisting of -H, methyl, ethyl, hydroxyl, methoxy, ethoxy, amino, mercapto, and sulfide group; wherein m is an integer ranging from 0 to 2.

In a preferred embodiment, the aqueous plating bath composition according to the invention comprises (iii) at least one cyanide group containing aromatic compound selected from compounds according to Formula (I) and/or Formula (II), salts thereof, and mixtures of the aforementioned,
wherein R1, R2, R3, R4, R5, R6 are selected independently of each other from the group consisting of R7, -H, methyl, ethyl, methoxy, ethoxy group, -NH₂, -NHCH₃, -N(CH₃)₂, -NHC₂H₅, -N(C₂H₅)₂, -SH, -SCH₃, -SC₂H₅, fluorine, chlorine, bromine, iodine; and wherein one of R1 to R6 is R7; and
wherein R8 is selected from the group consisting of -H, methyl, ethyl, hydroxyl, methoxy, ethoxy group, -NH₂, -NHCH₃, -N(CH₃)₂, -NHC₂H₅, -N(C₂H₅)₂, -SH, -SCH₃, and -SC₂H₅; wherein n is an integer ranging from 0 to 1; and
wherein R9, R10, R11, R12, R13, R14 are selected independently of each other from the group consisting of R15, -H, methyl, ethyl, methoxy, ethoxy group, -NH₂, -NHCH₃, -N(CH₃)₂, -NHC₂H₅, -N(C₂H₅)₂, -SH, -SCH₃, -SC₂H₅, fluorine, chlorine, bromine, iodine; and wherein one of R9 to R14 is R15; and
wherein R16 is selected from the group consisting of -H, methyl, ethyl, hydroxyl, methoxy, ethoxy group, -NH₂, -NHCH₃, -N(CH₃)₂, -NHC₂H₅, -N(C₂H₅)₂, -SH, -SCH₃, and -SC₂H₅; wherein m is an integer ranging from 0 to 1.

In a further preferred embodiment, the aqueous plating bath composition according to the invention comprises (iii) at least one cyanide group containing aromatic compound according to Formula (I) and/or Formula (II), salts thereof, and mixtures of the aforementioned, wherein the at least one cyanide group containing aromatic compound is selected from the group comprising:
3-chlorobenzonitrile, 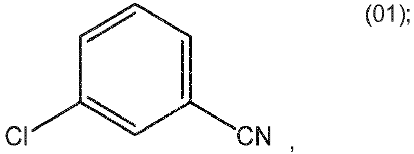
4-amino-2-chlorobenzonitrile, 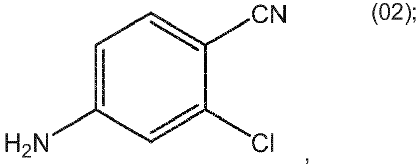
2-hydroxy-2-(pyridine-3-yl)acetonitrile, 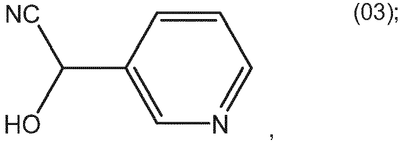
2-amino-2-(pyridine-3-yl)acetonitrile, 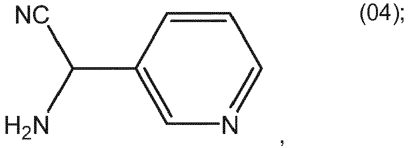
picolinonitrile, 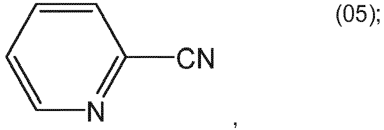
nicotinonitrile, 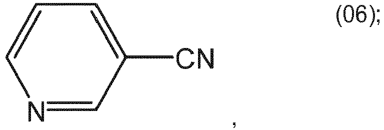
isonicotinonitrile, 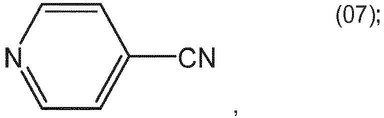
pyridine-3,5-dicarbonitrile, 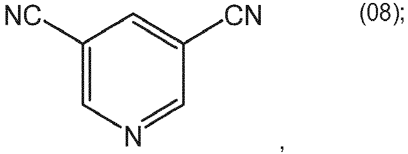
2-aminopyridine-3,5-dicarbonitrile, 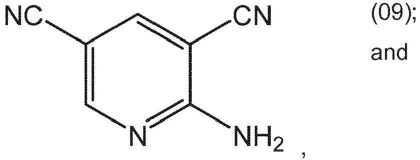
pyrimidine-2-carbonitrile,

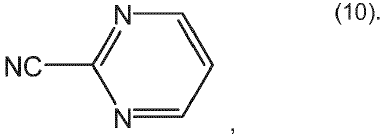

In a more preferred embodiment, the at least one cyanide group containing aromatic compound according to (iii) is selected from the group comprising 3-chlorobenzonitrile, 4-amino-2-chlorobenzonitrile, 2-hydroxy-2-(pyridine-3-yl)acetonitrile, 2-amino-2-(pyridine-3-yl)acetonitrile, picolinonitrile, nicotinonitrile, isonicotinonitrile, pyridine-3,5-dicarbonitrile, 2-aminopyridine-3,5-dicarbonitrile, and pyrimidine-2-carbonitrile; even more preferably 3-chlorobenzonitrile, 4-amino-2-chlorobenzonitrile, 2-hydroxy-2-(pyridine-3-yl)acetonitrile, 2-amino-2-(pyridine-3-yl)acetonitrile, picolinonitrile, nicotinonitrile, pyridine-3,5-dicarbonitrile, 2-aminopyridine-3,5-dicarbonitrile and pyrimidine-2-carbonitrile; even more preferably 3-chlorobenzonitrile, 4-amino-2-chlorobenzonitrile, 2-hydroxy-2-(pyridine-3-yl)acetonitrile, 2-amino-2-(pyridine-3-yl)acetonitrile, picolinonitrile, nicotinonitrile, and isonicotinonitrile; most preferably 3-chlorobenzonitrile, 4-amino-2-chlorobenzonitrile, 2-hydroxy-2-(pyridine-3-yl)acetonitrile and 2-amino-2-(pyridine-3-yl)acetonitrile.

In so far as the term "alkyl" is used in this description and in the claims, it refers to a hydrocarbon radical with the general chemical formula CₙH₂ₙ₊₁, n being an integer from 1 to 6. Alkyl residues can be linear and/or branched and they are saturated. For example, a linear C1 to C6 alkyl group or a branched C3 to C6 alkyl group may include methyl, ethyl, propyl, butyl, pentyl or hexyl.

In so far as the term "alkoxy" is used in this description and in the claims, it refers to a radical with the general chemical formula O-CₙH₂ₙ₊₁, n being an integer from 1 to 6. Alkoxy residues can be linear and/or branched and they are saturated. For example, a linear C1 to C6 alkoxy group or a branched C3 to C6 alkoxy group may include methoxy, ethoxy, propoxy, butoxy, pentoxy or hexoxy.

Preferably, the at least one cyanide group containing aromatic compound according to Formula (I) or at least one cyanide group containing aromatic compound selected from compounds according to Formula (II) has a concentration in the aqueous plating bath composition according to the invention ranging from 0.01 to 100 mg/l; preferably from 0.05 to 50 mg/l; more preferably from 0.01 to 20 mg/l. In one embodiment, more than one of the cyanide group containing aromatic compound according to Formula (I) and/or Formula (II) are present in the aqueous plating bath composition according to the invention and the concentration of each individual cyanide group containing aromatic compound is in the ranges as defined above. In another embodiment, more than one of the cyanide group containing aromatic compound according to Formula (I) and/or Formula (II) are present in the aqueous plating bath composition according to the invention and the sum of concentrations of all cyanide group containing aromatic compounds is in the concentration ranges as defined above.

The aqueous plating bath composition according to the invention comprises at least one source for palladium ions. Preferably, the at least one source for palladium ions is a water soluble palladium compound. More preferably, the at least one source for palladium ions is selected from the group comprising palladium chloride, palladium acetate, palladium sulfate and palladium perchlorate. Optionally, complex compounds comprising a palladium ion and a complexing agent, preferably a nitrogenated complexing agent, for palladium ions can be added to the plating bath instead of forming such a complex compound in the plating bath by adding a palladium salt and said complexing agent for palladium ions to the plating bath as separate ingredients. Suitable complex compounds as sources for palladium ions are for example complex compounds comprising palladium ions and complexing agents; preferably nitrogenated complexing agents; more preferably ethane-1,2-diamine and/or alkyl substituted ethane-1,2-diamines. Suitable complex compounds may further comprise counter ions to palladium ions; preferably chloride, acetate, sulfate or perchlorate. Suitable nitrogenated complexing agents and alkyl substituted ethane-1,2-diamines are defined below as complexing agents. Preferably, suitable complex compounds as sources for palladium ions are for example dichloro ethane-1,2-diamine palladium, diacetato ethane-1,2-diamine palladium; dichloro N¹-methylethane-1,2-diamine palladium; diacetato N¹-methylethane-1,2-diamine; dichloro N¹,N²-dimethylethane-1,2-diamine; diacetato N¹,N²-dimethylethane-1,2-diamine; dichloro N¹-ethylethane-1,2-diamine; diacetato N¹-ethylethane-1,2-diamine, dichloro N¹,N²-diethylethane-1,2-diamine; and diacetato N¹,N²-diethylethane-1,2-diamine.

The concentration of palladium ions in the composition ranges from 0.5 to 500 mmol/l, preferably from 1 to 100 mmol/l.

The aqueous plating bath composition according to the invention further comprises at least one reducing agent for palladium ions. The reducing agent makes the plating bath an autocatalytic, i.e. an electroless plating bath. Palladium ions are reduced to metallic palladium in the presence of said reducing agent. This plating mechanism differentiates the plating bath according to the invention from 1) immersion-type palladium plating baths which do not contain a reducing agent for palladium ions and 2) plating baths for electroplating of palladium which require an external electrical current in order to deposit a palladium layer.

The at least one reducing agent for palladium ions is preferably a chemical reducing agent. Reducing agents provide the electrons necessary to reduce metal ions to their metallic form and thereby form a metal deposit on a substrate. More preferably, the at least one reducing agent for palladium ions is a non-metallic reducing agent, e.g. the reducing agent is not tin compounds or tin ions.

Even more preferably, the at least one reducing agent for palladium ions is selected from the group comprising hypophosphorous acid, amine boranes, borohydrides, hydrazine, formaldehyde, formic acid, derivatives of the aforementioned and salts thereof.

Yet even more preferably, the at least one reducing agent for palladium ions is a reducing agent for depositing pure palladium deposits. Pure palladium deposits are deposits containing palladium in an amount ranging from 98.0 to 99.99 wt.-% or higher, preferably from 99.0 to 99.99 wt.-% or higher.

Yet even more preferably, the at least one reducing agent for palladium ions is selected from the group consisting of hydrazine, formaldehyde, formic acid, derivatives of the aforementioned and salts thereof.

Yet even more preferably, the at least one reducing agent for palladium ions is selected from the group consisting of formic acid, derivatives of formic acid and salts of the aforementioned. The aqueous plating bath composition according to the invention is particularly suitable for depositing palladium layers in the presence of formic acid, derivatives and salts of the aforementioned as reducing agent.

Suitable counter ions for salts of the at least one reducing agent for palladium ions are for example selected from lithium, sodium, potassium and ammonium.

Preferably, the concentration of the at least one reducing agent for palladium ions in the aqueous plating bath composition according to the invention ranges from 10 to 1000 mmol/l.

The aqueous plating bath composition of the invention is particularly suitable for depositing pure palladium layers. Pure palladium layers are particularly suitable for high temperature applications like in motor control units as pure palladium layers allow for sufficient thermal stability of bonded or soldered connections.

For depositing pure palladium layers, hypophosphorous acid and/or amine boranes and/or borohydrides, derivatives of the aforementioned and salts thereof are not suitable as the reducing agent because palladium alloy layers are deposited from plating bath compositions containing such reducing agents.

The aqueous plating bath composition according to the invention may further comprise at least one complexing agent for palladium ions. A complexing agent (sometimes also referred to as chelating agent) keeps metal ions dissolved and prevents their undesired precipitation from solution.

Preferably, the at least one complexing agent is a nitrogenated complexing agent for palladium ions. More preferably, the at least one nitrogenated complexing agent is selected from the group comprising primary amines, secondary amines and tertiary amines. Even more preferably, the at least one nitrogenated complexing agent is selected from the group comprising diamines, triamines, tetraamines and higher homologues thereof. The nitrogenated complexing agent or the primary amines, secondary amines and tertiary amines or the diamines, triamines, tetraamines and higher homologues thereof are no cyanide group containing aromatic compounds according to Formula (I) and/or Formula (II) having an amino group as substituent. Vice versa, the cyanide group containing aromatic compounds according to Formula (I) and/or Formula (II) are preferably different from the at least one complexing agent for palladium ions, more preferably from the at least one nitrogenated complexing agent, if the cyanide group containing aromatic compounds according to Formula (I) and/or Formula (II) are selected from cyanide group containing aromatic compounds having one or more amino groups as substituents.

Suitable amines are for example ethane-1,2-diamine (NH₂-CH₂-CH₂-NH₂, ethylene diamine); alkyl substituted ethane-1,2-diamines; 1,3-diamino-propane; 1,2-bis (3-aminopropyl-amino)-ethane; diethylene-triamine; diethylene-triamine-penta-acetic acid; N-(2-hydroxy-ethyl)-ethylene-diamine; ethylene-diamine-N,N-diacetic acid; 1,2-diamino-propyl-amine; 1,3-diamino-propyl-amine; 3-(methyl-amino)-propyl-amine; 3-(dimethyl-amino)-propyl-amine; 3-(diethyl-amino)-propyl-amine; bis-(3-amino-propyl)-amine; 1,2-bis-(3-amino-propyl)-alkyl-amine; diethylene-triamine; triethylene-tetramine; tetraethylene-pentamine; penta-ethylene-hexamine and mixtures thereof.

Suitable alkyl substituted ethane-1,2-diamines are for example N¹-methylethane-1,2-diamine (CH₃-NH-CH₂-CH₂-NH₂); N¹,N²-dimethylethane-1,2-diamine (CH₃-NH-CH₂-CH₂-NH-CH₃); N¹,N¹-dimethylethane-1,2-diamine ((CH₃)₂-N-CH₂-CH₂-NH₂); N¹,N¹,N²-trimethylethane-1,2-diamine ((CH₃)₂-N-CH₂-CH₂-NH-CH₃); N¹,N¹,N²,N²-tetramethylethane-1,2-diamine ((CH₃)₂-N-CH₂-CH₂-N-(CH₃)₂); N¹-ethylethane-1,2-diamine (C₂H₅-NH-CH₂-CH₂-NH₂); N¹,N²-diethylethane-1,2-diamine (C₂H₅-NH-CH₂-CH₂-NH-C₂H₅); N¹-ethyl-N²-methylethane-1,2-diamine (C₂H₅-NH-CH₂-CH₂-NH-CH₃); N¹-ethyl-N¹-methylethane-1,2-diamine ((CH₃)(C₂H₅)-N-CH₂-CH₂-NH₂); N¹,N¹-diethylethane-1,2-diamine ((C₂H₅)₂-N-CH₂-CH₂-NH₂); N¹-ethyl-N¹,N²-dimethylethane-1,2-diamine ((CH₃)(C₂H₅)-N-CH₂-CH₂-NH-CH₃); N¹,N²-diethyl-N¹-methylethane-1,2-diamine ((CH₃)(C₂H₅)-N-CH₂-CH₂-NH-(C₂H₅)); N¹,N¹-diethyl-N²-methylethane-1,2-diamine ((C₂H₅)₂-N-CH₂-CH₂-NH-CH₃); N¹,N¹,N²-triethylethane-1,2-diamine ((C₂H₅)₂-N-CH₂-CH₂-NH-C₂H₅); N¹-ethyl-N¹,N²,N²-trimethylethane-1,2-diamine ((CH₃)(C₂H₅)-N-CH₂-CH₂-N-(CH₃)₂); N¹,N²-diethyl-N¹,N²-dimethylethane-1,2-diamine ((CH₃)(C₂H₅)-N-CH₂-CH₂-N-(CH₃)(C₂H₅)); N¹,N¹-diethyl-N²,N²-dimethylethane-1,2-diamine ((C₂H₅)₂-N-CH₂-CH₂-N-(CH₃)₂); N¹,N¹,N²-triethyl-N²-methylethane-1,2-diamine ((C₂H₅)₂-N-CH₂-CH₂-N-(CH₃)(C₂H₅)); N¹,N¹,N²,N²-tetraethylethane-1,2-diamine ((C₂H₅)₂-N-CH₂-CH₂-N-(C₂H₅)₂) and mixtures thereof.

Preferably, the mole ratio of the complexing agent for palladium ions and palladium ions in the composition according to the invention ranges from 0.5 : 1 to 50 : 1, more preferably from 1 : 1 to 50 : 1, even more preferably from 2 : 1 to 20 : 1, most preferably from 5 : 1 to 10 : 1.

Optionally, the at least one cyanide group containing aromatic compound selected from compounds according to Formula (I) and/or Formula (II) is present in the aqueous plating bath composition according to the invention together with at least one further stabilizing agent. Stabilizing agents, also referred to as stabilizers, are compounds that stabilize an electroless metal plating solution against undesired outplating in the bulk solution and spontaneous decomposition. The term "outplating" means undesired and/or uncontrolled deposition of the metal on surfaces other than substrate surfaces.

The at least one further stabilizing agent may be selected from the group comprising compounds of the elements selenium, tellurium, copper, nickel, and iron and/or mercapto-benzothiazole, seleno-cyanates, thiourea, saccharin, ferro-cyanates; 4-nitrobenzoic acid; 3,5-dinitrobenzoic acid; 2,4-dinitrobenzoic acid; 2-hydroxy-3,5-dinitrobenzoic acid; 2-acetylbenzoic acid; 4-nitrophenol and their corresponding ammonium, sodium and potassium salts.

Preferably, the concentration of such further stabilizing agents in the composition according to the invention ranges from 0.01 to 500 mg/l, more preferably from 0.1 to 200 mg/l, even more preferably from 1 to 200 mg/l, and most preferably from 10 to 100 mg/l.

Preferably, however, the aqueous plating bath composition according to the invention is essentially free of the aforementioned further stabilizing agents selected from the group comprising compounds of the elements selenium, tellurium, copper, nickel, iron and/or mercapto-benzothiazole, seleno-cyanates, thiourea and ferro-cyanates because such further stabilizing agents are either co-deposited with palladium (e.g. copper ions) and thereby form a palladium alloy which is not preferred, or are toxic substances (e.g. thiourea).

Preferably, the aqueous plating bath composition according to the invention is an acidic plating bath. The pH-value of the aqueous plating bath composition more preferably ranges from 4 to 7, even more preferably from 5 to 6. The pH preferably is adjusted using pH adjustors selected from sodium hydroxide, potassium hydroxide, caesium hydroxide, sulfuric acid and methane sulfonic acid.

The invention further relates to a method for electroless palladium plating comprising the steps of
a) providing a substrate,
b) contacting the substrate with the aqueous plating bath composition according to the invention and thereby depositing a layer of palladium onto at least a portion of the substrate.

Preferably, the method steps are performed in the order described above. Preferably, the substrate has a metal surface.

Electroless palladium plating or electroless deposition of palladium is preferably carried out by contacting a substrate having a metal surface with the composition according to the invention and thereby depositing a layer of palladium onto at least a portion of the metal surface of the substrate. Preferably, the metal surface or the portion thereof to be coated with palladium is selected from the group comprising copper, copper alloys, nickel, nickel alloys, cobalt, cobalt alloys, platinum, platinum alloys, gold, gold alloys, and gallium arsenide. The metal surface or the portion thereof to be coated is for example part of a printed circuit board, an IC substrate or a semiconducting wafer. Palladium layers are used for example on semiconducting wafers as noble metal, wire-bondable and solderable finishes of semiconductor chips, light emitting diodes (LED) or solar cells.

Suitable methods for contacting the substrate with the aqueous plating bath composition are for example dipping the substrate into the composition or spraying the composition onto the substrate.

Preferably, the substrate is contacted with the aqueous plating bath composition according to step b) at a temperature of 30 to 95°C, more preferably of 30 to 85°C, even more preferably of 50 to 85°C, yet even more preferably of 30 to 65°C. Preferably, the substrate is contacted with the composition for 1 to 60 min, more preferably for 5 to 20 min. Preferably, the substrate is contacted with the aqueous plating bath composition to give a palladium plated layer ranging in thickness from 0.01 to 5.0 µm, more preferably from 0.02 to 2.0 µm and even more preferably from 0.05 to 0.5 µm.

The thickness of palladium layers was measured by x-ray fluorescence (XRF) which is well known to persons skilled in the art. The XRF measurements make use of the characteristic fluorescence radiation emitted from a sample (substrate, deposit) being excited with x-rays. By evaluating the wavelength and intensities and assuming a layered structure of the sample, layer thicknesses can be calculated.

In one embodiment of the invention, a thin activation layer of palladium is first deposited onto the substrate, preferably a substrate having a metal surface, by an immersion-type plating method (exchange reaction) followed by palladium deposition from the aqueous plating bath composition according to the invention.

Activation methods for the metal surface prior to electroless palladium deposition are known in the art and can be applied to work within the invention. A suitable aqueous activation bath may comprise a palladium salt such as palladium acetate, palladium sulfate, palladium chloride and palladium nitrate, an acid such as nitric acid, sulfuric acid and methane sulfonic acid and optionally a complexing agent for palladium ions such as primary amines, secondary amines, tertiary amines and ethanolamines. Optionally, such an activation bath further contains an oxidizing agent such as nitrate ions, perchlorate ions, chlorate ions, perborate ions, periodate ions, peroxo-disulfate ions and peroxide ions.

The concentration of the palladium salt in the aqueous activation bath ranges from 0.005 to 20 g/l, preferably from 0.05 to 2.0 g/l. The concentration of the complexing agent for palladium ions ranges from 0.01 to 80 g/l, preferably from 0.1 to 8 g/l.

The pH-value of the aqueous activation bath preferably ranges from 0 to 5, preferably from 1 to 4.

Typically, the substrates are immersed in the aqueous activation bath at 25 to 30°C for one to four minutes. Prior to immersing the substrate in an aqueous activation bath, the metal surface of the substrate is cleaned. For this purpose, etch cleaning is usually carried out in oxidizing, acidic solutions, for example a solution of sulfuric acid and hydrogen peroxide. Preferably, this is followed by another cleaning in an acidic solution, such as, for example, a sulfuric acid solution.

The cyanide group containing aromatic compounds according to Formula (I) and/or Formula (II) provide the aqueous plating bath composition according to the invention with an improved stability against undesired decomposition. Further, the cyanide group containing aromatic compounds according to Formula (I) and/or Formula (II) provide the aqueous plating bath composition with a prolonged life time because the undesired decomposition of the plating bath is suppressed. Thus, the cyanide group containing aromatic compounds according to Formula (I) and/or Formula (II) act as stabilizing agents in the aqueous plating bath composition for electroless deposition of palladium, in particular for electroless deposition of pure palladium.

Shortened life time of an electroless palladium plating bath may be due to contaminations which cause undesired decomposition of the bath. Electroless palladium plating baths are sensitive to contaminations, in particular to metal ions. The cyanide group containing aromatic compounds according to Formula (I) and/or Formula (II) provide the aqueous plating bath composition according to the invention with decreased sensitivity to contaminations, in particular to metal ions.

The aqueous plating bath composition and the method for electroless palladium plating according to the invention enable plating of palladium layers having desired properties such as low internal stress and sufficient adhesion to the underlying substrate.

A deposited palladium layer having low stress is of advantage as it has a better adhesion to the subjacent substrate surface. In contrast, a palladium layer having high stress may delaminate from the subjacent substrate surface. This causes gaps between the palladium layer and the substrate surface. These gaps may be entered by process solutions of subsequent manufacturing steps or by gases which in turn results in corrosion.

If the substrate is a silicon wafer, depositing a palladium layer having high stress causes the wafer to bend or even to break. If the wafer does not have a perfect flat profile any more subsequent manufacturing steps like transporting or lithographic steps become difficult to perform as the manufacturing equipment does not fit to a bent form of the wafer. Thus, a bent or broken wafer is a high loss.

In addition, depositing palladium layers having low stress using the aqueous plating bath composition and method of the invention is possible even at low temperatures like 30 to 65°C in comparison to known electroless palladium plating compositions and methods. Operating the bath at a higher temperature may increase the risk of destabilising the bath. It requires higher energy consumption. It may be of disadvantage for layers of some metals also present on the substrate to be plated. For example, aluminium or copper layers may suffer corrosion when present on a substrate which is plated with palladium from a deposition bath at higher temperatures. The cyanide group containing aromatic compounds according to Formula (I) and/or Formula (II) of the invention allow for electrolessly depositing palladium layers at lower temperatures ranging from 30 to 65°C. Thus, stability of the aqueous plating bath compositions of the invention is maintained and corrosion of metal layers also present on the substrate during deposition of palladium from the composition is prevented.

Furthermore, the stable performance of the aqueous plating bath composition in the method for electroless palladium plating of the invention allows deposition of palladium layers having the desired properties over an extended period of time in comparison to methods for electroless palladium plating known in the art.

The plating bath according to the invention has an improved stability against undesired decomposition due to the cyanide group containing aromatic compounds according to Formula (I) and/or Formula (II) while keeping the deposition rate for palladium onto a substrate at the desired satisfying value. Adding the cyanide group containing aromatic compounds according to Formula (I) and/or Formula (II) to an electroless palladium plating bath allows for adjusting the deposition rate to satisfying values over the bath life time.

The cyanide group containing aromatic compounds according to Formulae (I) and (II) of the invention decrease the deposition rate of aqueous plating bath compositions for electroless deposition of palladium, in particular for electroless deposition of pure palladium.

The deposition rate of known electroless palladium deposition baths is usually influenced by a number of factors, e.g. by the age of the deposition bath and possible contaminations. The deposition rate of freshly prepared palladium deposition baths is usually high and subsequently decreases during bath life. Thus, in the beginning of plating, palladium layers of higher thickness are obtained than at a later time during utilization of the bath for plating. In the industrial manufacturing of palladium plated substrates it is desired to produce palladium layers of constant thickness and quality. Thus, a change in palladium layer thickness and quality during the bath life is undesired.

Adding initially the cyanide group containing aromatic compounds according to Formula (I) and/or Formula (II) to a freshly prepared electroless palladium plating bath or shortly after beginning of plating decreases the initially too high deposition rate to the desired satisfying range. After some time of plating the deposition rate drops due to aging of the electroless palladium plating bath. Simultaneously, the amount of cyanide group containing aromatic compounds according to Formula (I) and/or Formula (II) drops due to consumption and/or drag-out. The effects of dropping deposition rate and dropping amount of cyanide group containing aromatic compounds may compensate for each other and thus, the deposition rate stays within the desired range. Or amounts of the cyanide group containing aromatic compounds according to Formula (I) and/or Formula (II) which are smaller than the initially added amounts may be dosed to the electroless palladium plating bath in order to keep the deposition rate within the desired satisfying range.

Further, contaminations of an electroless palladium plating bath, e.g. contaminating organic compounds originating from ingredients of the plating bath, may increase the deposition rate of the electroless palladium plating bath to an undesired high value. By adding the cyanide group containing aromatic compounds according to Formula (I) and/or Formula (II) to an electroless palladium plating bath containing such contaminations the too high deposition rate is decreased to the desired range.

Thus, adding the cyanide group containing aromatic compounds according to Formula (I) and/or Formula (II) to an electroless palladium plating bath allows for adjusting the deposition rate to a satisfying range over the bath life time. This ensures depositing palladium layers of constant thickness and quality throughout the life time of an electroless palladium plating bath and facilitates process control of the manufacturing process. Adjusting the deposition rate to a satisfying range over the bath life time also prolongs the life time of an electroless palladium plating bath.

The satisfying range, satisfying value, desired range or desired value of the deposition rate means herein that the deposition rate of palladium from an electroless plating bath is high enough to fulfil the requirements for an industrial palladium plating method, i.e. high enough to allow for economical manufacturing. At the same time such a deposition rate is only as low as required in order to ensure long lasting bath stability against undesired decomposition and depositing palladium layers of constant thickness and quality throughout the life time of an electroless palladium plating bath.

Thus, the invention further relates to a method for adjusting the deposition rate of any aqueous electroless palladium deposition bath, preferably to a method for adjusting the deposition rate to a satisfying range over life time of any aqueous electroless palladium deposition bath, the method comprises the steps of
c) providing any aqueous electroless palladium deposition bath, and
d) adding at least one cyanide group containing aromatic compound according to Formula (I) and/or Formula (II) to the electroless palladium deposition bath,
e) and thereby decreasing the deposition rate of the aqueous electroless palladium deposition bath.

The electroless palladium deposition bath may be any aqueous electroless palladium deposition bath. In one embodiment the electroless palladium deposition bath is the aqueous plating bath composition according to the invention.

In one embodiment of the invention the aqueous electroless palladium deposition bath may be a freshly prepared electroless palladium deposition bath.

In another embodiment the aqueous electroless palladium deposition bath may be an aged electroless palladium deposition bath. Aged electroless palladium plating bath means herein an electroless palladium plating bath already used for some time for plating.

Further, in a preferred embodiment, the aqueous electroless palladium deposition bath is a bath for electroless deposition of pure palladium.

The deposition rate and/or the concentration of the at least one cyanide group containing aromatic compound according to Formula (I) and/or Formula (II) may be determined during plating or storage. If the deposition rate is above a threshold value or the concentration of the at least one cyanide group containing aromatic compound according to Formula (I) and/or Formula (II) is below a threshold value, the at least one cyanide group containing aromatic compound according to Formula (I) and/or Formula (II) is replenished. Replenishment is performed by adding the at least one cyanide group containing aromatic compound according to Formula (I) and/or Formula (II) to the aqueous electroless palladium deposition bath. Preferably, the at least one cyanide group containing aromatic compound according to Formula (I) and/or Formula (II) is dosed to the electroless palladium plating bath in an amount corresponding to the deviation from one or both threshold values.

Thus, preferably the method for adjusting the deposition rate of any aqueous electroless palladium deposition bath, more preferably the method for adjusting the deposition rate to a satisfying range over life time of any aqueous electroless palladium deposition bath, comprises one or more of further steps
c.i) determining the deposition rate and/or the concentration of the at least one cyanide group containing aromatic compound according to Formula (I) and/or Formula (II) within the aqueous electroless palladium deposition bath according to step c);
c.ii) comparing the value for deposition rate and/or concentration of the at least one cyanide group containing aromatic compound according to Formula (I) and/or Formula (II) determined according to step c.i) with pre-set corresponding threshold values;
c.iii) determining the deviation of the value for deposition rate and/or concentration of the at least one cyanide group containing aromatic compound according to Formula (I) and/or Formula (II) from their corresponding threshold values;
c.iv) correlating the deviation determined according to step c.iii) to an amount of the at least one cyanide group containing aromatic compound according to Formula (I) and/or Formula (II) to be added to the aqueous electroless palladium deposition bath in step d).

Preferably, the method for adjusting the deposition rate according to the invention is applied if the deposition rate of an electroless palladium deposition bath is higher than desired. Then, adding at least one cyanide group containing aromatic compound according to Formula (I) and/or Formula (II) of the invention decreases the deposition rate of an electroless palladium deposition bath to the desired range.

Determining the deposition rate may be performed according to methods known in the art, e.g. by the methods described in the Examples herein. Determining the concentration of organic compounds like the at least one cyanide group containing aromatic compound according to Formula (I) and/or Formula (II) may be performed according to methods known in the art.

Alternatively, if the dropping behaviour of deposition rate of an electroless palladium deposition bath is already known, the cyanide group containing aromatic compound according to Formula (I) and/or Formula (II) may be dosed permanently or periodically to the deposition bath in pre-set amounts. Preferably, the amounts to be dosed to the deposition bath of the cyanide group containing aromatic compound according to Formula (I) and/or Formula (II) decrease over life time of the bath.

The at least one cyanide group containing aromatic compound according to Formula (I) and/or Formula (II) may be added as a solid or a powder or may be dissolved in a solvent prior to its addition to the electroless palladium deposition baths. Examples for suitable solvents are water; acids like sulphuric acid, hydrochloric acid, phosphoric acid; alkaline solutions like solutions of sodium hydroxide or potassium hydroxide; and organic solvents like propanol, ethanol, methanol.

The invention further relates to uses of the at least one cyanide group containing aromatic compounds according to Formula (I) and/or Formula (II) for
stabilizing any aqueous electroless palladium deposition bath composition, preferably an aqueous plating bath composition for electroless deposition of palladium according to the invention, against undesired decomposition;
expanding the life time of any aqueous electroless palladium deposition bath composition, preferably an aqueous plating bath composition for electroless deposition of palladium according to the invention;
decreasing sensitivity of any aqueous electroless palladium deposition bath composition, preferably an aqueous plating bath composition for electroless deposition of palladium according to the invention, to contaminations, preferably to metal ions;
adjusting the deposition rate of any aqueous electroless palladium deposition bath, preferably an aqueous plating bath composition for electroless deposition of palladium according to the invention; and/or
adjusting the deposition rate to a satisfying range over the life time of any aqueous electroless palladium deposition bath, preferably an aqueous plating bath composition for electroless deposition of palladium according to the invention.

"Expanding the life time" herein also means "increasing", "prolonging" or "extending" the life time.

### Examples

The invention is further explained by the following non-limiting examples.

The preparation examples relate to the synthesis of the cyanide group containing aromatic compounds employed in the aqueous plating bath composition of the invention.

### Preparation Example 1

### Preparation of 2-hydroxy-2-(pyridine-3-yl)acetonitrile

In a 50 mL glass reactor 5.28g (77.022 mmol) potassium cyanide were dis-solved in 18 mL water. To this mixture 6.71 mL (70.02 mmol) nicotinaldehyde were added at 5°C over 60 minutes. After adding the aldehyde a yellow solution occurred. To this mixture an aqueous solution of 2-hydroxypropane1,2,3-tricarboxylic acid (6.05 g (31.5 mmol) in 12 mL water) were added over 30 minutes at 5°C. After addition the occuring yellow suspension was heated to ambient temperature and stirred over night. The reaction mixture was extracted with ethyl acetate (3 x 25 mL) and the combined organic phases were dried over magnesium sulfate. After removal of the solvent 8.51g (91%) of a pale yellow solid were obtained.
δ(CDCl₃; 250 MHz; Bruker AC 250): 8.61 (dd; ⁴J_{HH} = 2.5 Hz; 1H); 8.51 (d; ³J_{HH} = 5 Hz; 1H); 7.955 (d; ³J_{HH} = 7.5 Hz; 1H); 7,425 (dd; ³J_{HH} = 7.5 Hz; ⁴J_{HH} = 2.5 Hz; 1H); 6.75 (bs, 1H); 5.66 (s; 1H)

### Preparation Example 2

### Preparation of 2-amino-2-(pyridine-3-yl)acetonitrile

24.5 g (0.458 mol) ammonium chloride and 7 mL (0.0931 mol) aqueous ammo-nia solution (25 wt-%) were dissolved in 61.1 mL water. To this mixture 10g (0.0745 mol) 2-hydroxy-2-(pyridine-3-yl)acetonitrile were slowly added and stirred at room temperature over night. The reaction mixture was extracted with methylene chloride (5 x 60 mL) and the combined organic phases were washed with brine. The combined organic phases were dried over sodium sulfate. After removal of the solvent 5.0g (50%) of a brownish oil were obtained.

The analytical data were in correspondance with the literature (Bioorganic & Medicinal Chemistry 2008, 16, 1376 - 1392).

### General procedure

### Palladium plating bath matrix and palladium plating:

Pre-treated substrates were plated with palladium according to the following procedure unless stated otherwise.

A plating bath matrix (Xenolyte Pd LL, product of Atotech Deutschland GmbH) having a pH-value of 5.5 and comprising water, palladium ions, sodium formate as reducing agent for palladium ions and ethylene diamine as complexing agent for palladium ions was used throughout all examples.

Different amounts of the cyanide group containing aromatic compound according to Formula (I) or Formula (II) of the invention were added to 2 I of individual palladium plating bath matrices throughout plating examples 1 and 2. The aqueous plating bath compositions were held at 60 °C during plating. The substrates were immersed into the aqueous plating bath compositions for 6 minutes. Afterwards, the substrates were rinsed with deionized water for 1 minute and dried with air pressure.

### Plating Example 1

### Substrates and pre-treatment:

Test chips made of silicon covered with a SiO₂ layer and having four dies each were used as substrates. Each die had several isolated pads of an aluminum-copper alloy on its surface. The pads had different sizes ranging from 10 µm to 1000 µm in diameter and distances between pads ranged from 20 µm to 1000 µm.

The test chips were already pre-treated by double-zincation. Afterwards, the test chips were nickel plated using an electroless nickel plating bath (Xenolyte Ni MP, product of Atotech Deutschland GmbH) containing a nickel(II) salt, a reducing agent for nickel ions, a complexing agent for nickel ions and a stabilizer. The nickel plating bath had a pH value of 4.5 and was held at 87 °C during plating. The test chips were immersed into the nickel plating bath for 10 minutes and a nickel layer of 3 µm thickness was plated onto the test chips. Afterwards, the test chips were rinsed in deionized water. and subjected to the following palladium plating bath compositions.

0 to 10 mg/l of cyanide group containing aromatic compounds according to Formula (I) (see table 1 for individual compounds and their concentrations) were added to the plating bath matrix. The pre-treated substrates were plated with palladium by subjecting them to the resulting palladium plating bath compositions. Plating was performed according to the General procedure.

The deposition rate was determined as follows. The thickness of the palladium layers deposited in various aqueous plating bath compositions tested was determined with an X-ray fluorescence method (XRF; Fischer, Fischerscope® X-Ray XDV®-11). The thickness was measured on four palladium pads for each substrate. The deposition rate for each aqueous plating bath composition was calculated by dividing the measured thickness of the palladium layers deposited by the plating time of 6 minutes.

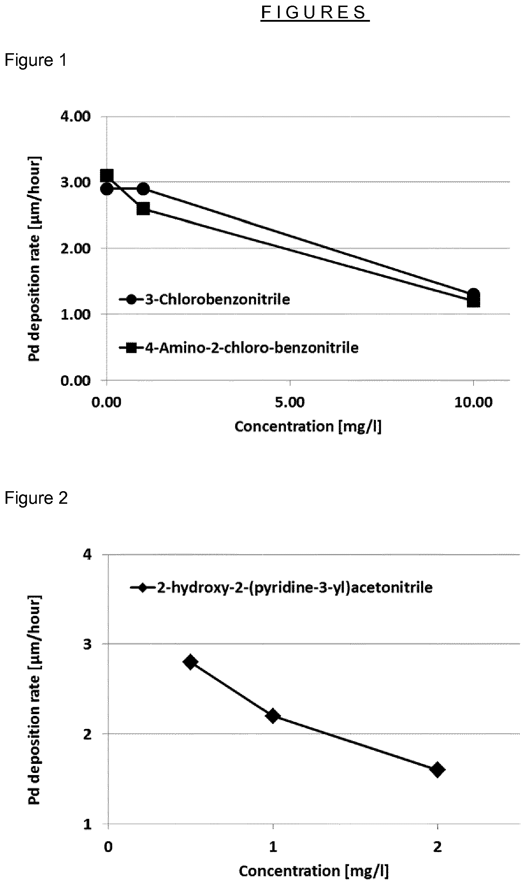

The aqueous plating bath compositions and mean values of deposition rates for each plating bath composition are summarised in table 1 and shown in Figure 1.

**Table 1: Deposition rate of aqueous plating bath compositions containing cyanide group containing aromatic compounds according to Formula (I) of the invention**

| | | 3-Chlorobenzonitrile | 4-Amino-2-chlorobenzonitrile |
|---|---|---|---|
| | Concentration [mg/l] | Deposition rate [µm/hour] | Deposition rate [µm/hour] |
| comparative | 0 | 2.9 | 3.1 |
| according to invention | 1 | 2.9 | 2.6 |
| | 10 | 1.3 | 1.2 |

3-Chlorobenzonitrile and 4-Amino-2-chloro-benzonitrile are commercially available, e.g. from Sigma-Aldrich Co. LLC.

### Plating Example 2

Copper plates having dimensions of 7 x 7 cm² were used as substrates. The copper plates were pre-treated by electrolytical degreasing (Nonacid 701, product of Atotech Deutschland GmbH), immersing into a sulfonic acid based pre-dip solution (Spherolyte special acid, product of Atotech Deutschland GmbH) and activating by an immersion type palladium bath (Aurotech SIT Activator, product of Atotech Deutschland GmbH) with a dense palladium layer.

0.5 to 5 mg/l of cyanide group containing aromatic compounds according to Formula (II) (see table 2) were added to the plating bath matrix. The pre-treated substrates were plated with palladium by subjecting them to the resulting palladium plating bath compositions. Plating was performed according to the General procedure.

The deposition rate was measured by weight gain, divided by the plating time of 6 minutes.

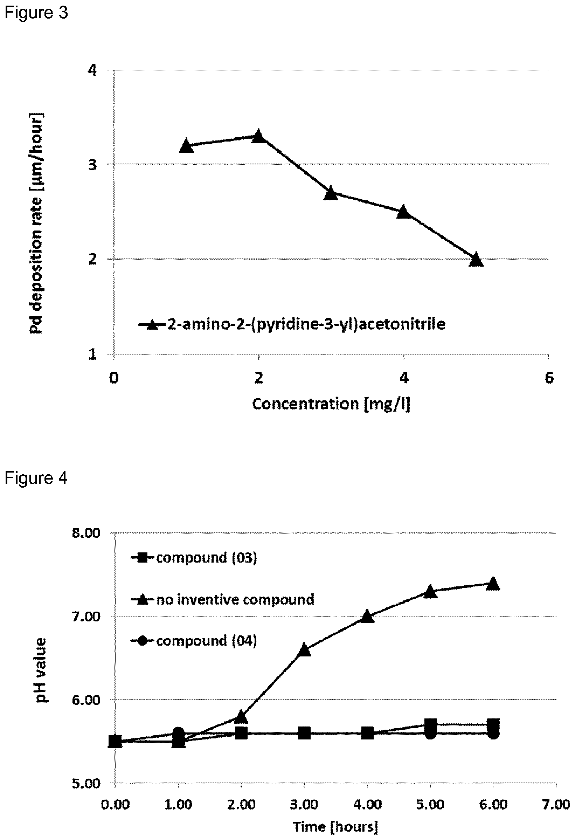

The aqueous plating bath compositions and plating results are summarised in Table 2 and shown in Figures 2 and 3.

**Table 2: Deposition rate of aqueous plating bath compositions containing cyanide group containing aromatic compounds according to Formula (II) of the invention**

| according to invention | 2-hydroxy-2-(pyridine-3-yl)acetonitrile (Preparation Example 1) | 2-amino-2-(pyridine-3-yl)acetonitrile (Preparation Example 2) |
|---|---|---|
| Concentration [mg/l] | Deposition rate [µm/hour] | Deposition rate [µm/hour] |
| 0.5 | 2.8 | --- |
| 1 | 2.2 | 3.2 |
| 2 | 1.6 | 3.3 |
| 3 | --- | 2.7 |
| 4 | --- | 2.5 |
| 5 | --- | 2.0 |

| | | |
|---|---|---|
| "---" means not measured | | |

### Summary of Results of Plating Examples 1 and 2

Examples 1 and 2 showed that the deposition rate of aqueous plating bath compositions containing cyanide group containing aromatic compounds according to Formula (I) or Formula (II) were lower compared to compositions lacking the cyanide group containing aromatic compounds. The deposition rate decreased with increasing concentration of the cyanide group containing aromatic compounds.

The deposits obtained from aqueous plating bath compositions containing cyanide group containing aromatic compounds according to Formula (I) or Formula (II) were ductile, had a grey colour and adhered very well to the substrates.

### Example 3: pH stability test

Cyanide group containing aromatic compounds according to Formula (II) (see table 3 for compounds and their concentrations) were added to 2 I of individual palladium plating bath matrices as described in the General procedures. The aqueous plating bath compositions were adjusted to an initial pH of 5.5. Afterwards they were heated up to 80 °C and held at this temperature throughout the test while stirring permanently. When the compositions reached 80 °C pH measurement was started. Samples were removed from the composition every hour and the pH value determined thereof. A portion of the plating bath matrix lacking cyanide group containing aromatic compounds of the invention (zero sample) was treated the same way in parallel.

When palladium is deposited from the composition the nitrogenated complexing agent is released from the complex of palladium and complexing agent. The release of nitrogenated complexing agent causes an increase of the pH value of the composition. This also happens when palladium precipitates or is deposited unwantedly due to instability and decomposition of the electroless palladium plating bath composition. Therefore, the change of the pH is a measure for the stability of the aqueous plating bath compositions of the invention.

The development of the pH value in the aqueous plating bath compositions is summarised in Table 3 and shown in Figure 4.

**Table 3: pH value of aqueous plating bath compositions containing cyanide group containing aromatic compounds according to Formula (II) of the invention**

| | 2-hydroxy-2-(pyridine-3-yl)-acetonitrile (Preparation Example 1) | | 2-amino-2-(pyridine-3-yl)-acetonitrile (Preparation Example 2) | |
|---|---|---|---|---|
| | Zero Sample: 0mg/l | 0.5 mg/l | Zero Sample: 0mg/l | 3 mg/l |
| Time [hours] | pH | pH | pH | pH |
| 0 | 5.5 | 5.5 | 5.5 | 5.5 |
| 1 | 5.5 | 5.5 | 5.5 | 5.6 |
| 2 | 5.8 | 5.6 | 5.6 | 5.6 |
| 3 | 6.6 | 5.6 | 5.6 | 5.6 |
| 4 | 7.0 | 5.6 | 5.8 | 5.6 |
| 5 | 7.3 | 5.7 | 6.4 | 5.6 |
| 6 | 7.4 | 5.7 | 6.8 | 5.6 |

The pH value of aqueous plating bath compositions containing the cyanide group containing aromatic compounds is nearly constant over time while in plating bath matrices lacking the cyanide group containing aromatic compounds the pH value significantly increases. Thus, Example 3 shows that aqueous plating bath compositions containing cyanide group containing aromatic compounds according to the invention have a significantly better stability against unwanted decomposition than the plating bath matrix lacking the cyanide group containing aromatic compounds.

### Example 4: Plating Example

The deposition rate of palladium plating baths containing different cyanide containing aromatic compounds was determined as described in Plating Example 2. The aqueous plating bath compositions and plating results are summarised in Table 4.

**Table 4: Deposition rate of aqueous plating bath compositions containing cyanide group containing aromatic compounds**

| Compound concentration / mg/l | 0 | 1 | 5 | 10 |
|---|---|---|---|---|
| 3-Chlorobenzonitrile Deposition rate / µm/hour | 3.5 | 2.0 | 1.1 | 0.5 |
| Nicotinonitrile Deposition rate / µm/hour | 3.7 | 1.8 | 0.4 | 0.2 |
| 4-Hydroxybenzo nitrile Deposition rate / µm/hour | 3.5 | 3.1 | 2.5 | 2.2 |
| 4-Cyano benzoic acid Deposition rate / µm/hour | 3.5 | 2.7 | 2.2 | 1.1 |

### Example 5: pH stability test

Stability of electroless palladium plating bath compositions against unwanted decomposition was measured as described in Example 3. Cyanide group containing aromatic compounds were added to separate portions of palladium plating bath matrices and measurements started. The aqueous plating bath compositions and development of the pH value in the aqueous plating bath compositions is summarised in Table 5.

**Table 5: pH value of aqueous plating bath compositions containing cyanide group containing aromatic compounds**

| | Zero Sample: 0 mg/l | Isonicotinonitrile 1 mg/l | 3-Hydroxybenzo nitrile 1 mg/l |
|---|---|---|---|
| Time [hours] | pH | pH | pH |
| 0 | 5.5 | 5.5 | 5.5 |
| 1 | 5.5 | 5.5 | 5.5 |
| 2 | 5.9 | 5.5 | 5.6 |
| 3 | 6.7 | 5.5 | 5.7 |
| 4 | 7.1 | 5.5 | 6.2 |
| 5 | 7.1 | 5.6 | 6.9 |
| 6 | 7.1 | 5.6 | 6.9 |
| | | | |

| | Zero Sample: 0 mg/l | 4-Cyano benzo sulfonic acid 5 mg/l | |
|---|---|---|---|
| Time [hours] | pH | pH | |
| 0 | 5.5 | 5.5 | |
| 1 | 5.5 | 5.5 | |
| 2 | 5.6 | 5.6 | |
| 3 | 5.8 | 5.9 | |
| 4 | 6.5 | 6.6 | |

## Claims

1. An aqueous plating bath composition for electroless deposition of palladium, comprising
(i) at least one source for palladium ions,
(ii) at least one reducing agent for palladium ions, and
(iii) at least one cyanide group containing aromatic compound selected from compounds according to Formula (I), salts thereof, and mixtures of the aforementioned; and/or at least one cyanide group containing aromatic compound selected from compounds according to Formula (II), salts thereof, and mixtures of the aforementioned; 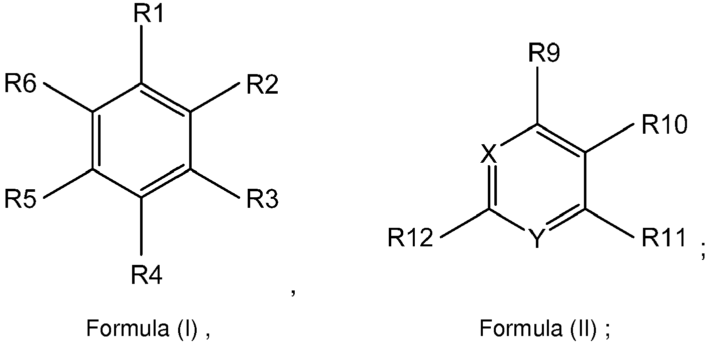 wherein R1, R2, R3, R4, R5, R6 are selected independently of each other from the group consisting of R7, -H, C1 to C6 alkyl group, C1 to C6 alkoxy group, amino, aldehyde, mercapto, sulfide group, halogen, allyl, vinyl, ethynyl, propynyl, 1-butynyl, 2-butynyl, 2-ethynylbenzene, phenyl, pyridyl, and naphthyl groups; wherein at least one of R1 to R6 is R7; wherein R7 is a moiety according to Formula (III), 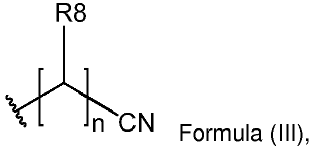
wherein each R8 is selected independently from the group consisting of -H, C1 to C6 alkyl group, hydroxyl, C1 to C6 alkoxy group, amino, mercapto, and sulfide group; wherein n is an integer ranging from 0 to 4; and
wherein X is selected from N and C-R13;
wherein Y is selected from N and C-R14; wherein at least one of X or Y is N; wherein R9, R10, R11, R12, R13, R14 are selected independently of each other from the group consisting of R15, -H, C1 to C6 alkyl group, hydroxyl, C1 to C6 alkoxy group, amino, aldehyde, carboxyl, ester, sulfonic acid, mercapto, sulfide group, halogen, allyl, vinyl, ethynyl, propynyl, 1-butynyl, 2-butynyl, 2-ethynylbenzene, phenyl, pyridyl, and naphthyl groups; wherein at least one of R9 to R14 is R15;
wherein R15 is a moiety according to Formula (IV), 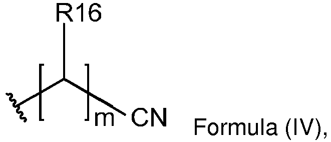
wherein each R16 is selected independently from the group consisting of -H, C1 to C6 alkyl group, hydroxyl, C1 to C6 alkoxy group, amino, mercapto, and sulfide group; wherein m is an integer ranging from 0 to 4, and
wherein, if at least one of X or Y is N. R15 is in the ortho or meta position in relation to N within the aromatic ring according to Formula (II).

2. The aqueous plating bath composition according to claim 1 wherein n is 0.

3. The aqueous plating bath composition according to claim 1 or 2 wherein at least one of R1 to R6 is halogen.

4. The aqueous plating bath composition according to any of the foregoing claims wherein at least one of R1 to R6 is halogen and at least one of R1 to R6 is amino.

5. The aqueous plating bath composition according to claim 1 wherein X is not N if Y is N; or Y is not N if X is N.

6. The aqueous plating bath composition according to claim 1 or 5 wherein m is an integer selected from 0 or 1.

7. The aqueous plating bath composition according to claims 1, 5 or 6 wherein when X is not N if Y is N, or when Y is not N if X is N, R15 is in meta position in relation to N within an aromatic ring according to Formula (II).

8. The aqueous plating bath composition according to any of the foregoing claims wherein the at least one cyanide group containing aromatic compound according to Formula (I) is selected from the group comprising 3-chlorobenzonitrile, 4-amino-2-chlorobenzonitrile, 2-hydroxy-2-(pyridine-3-yl)acetonitrile, 2-amino-2-(pyridine-3-yl)acetonitrile, picolinonitrile, nicotinonitrile, pyridine-3,5-dicarbonitrile, 2-aminopyridine-3,5-dicarbonitrile, and pyrimidine-2-carbonitrile.

9. The aqueous plating bath composition according to any of the foregoing claims, wherein the at least one cyanide group containing aromatic compound according to Formula (I) has a concentration ranging from 0.01 to 100 mg/l.

10. The aqueous plating bath composition according to any of the foregoing claims, wherein the pH-value ranges from 4 to 7.

11. The aqueous plating bath composition according to any of the foregoing claims, further comprising at least one complexing agent for palladium ions selected from the group consisting of primary amines, secondary amines and tertiary amines.

12. The aqueous plating bath composition according to claim 11, wherein the mole ratio of the complexing agent for palladium ions and palladium ions in the aqueous plating bath composition ranges from 0.5 : 1 to 50 : 1.

13. The aqueous plating bath composition according to any of the foregoing claims, wherein the at least one reducing agent for palladium ions is selected from the group comprising hypophosphorous acid, amine boranes, borohydrides, hydrazine, formaldehyde, formic acid, derivatives of the aforementioned and salts thereof.

14. The aqueous plating bath composition according to any of the foregoing claims, wherein the concentration of the at least one reducing agent ranges from 10 to 1000 mmol/l.

15. A method for electroless palladium plating comprising the steps of
a) providing a substrate,
b) contacting the substrate with the aqueous plating bath composition according to any of claims 1 to 14 and thereby depositing a layer of palladium onto at least a portion of the substrate.

16. The method for electroless palladium plating according to claim 15 wherein the substrate is contacted with the aqueous plating bath composition at a temperature of 30 to 65°C in step b).

17. A method for adjusting the deposition rate of any aqueous electroless palladium deposition bath, the method comprises the steps of
c) providing any aqueous electroless palladium deposition bath, and
d) adding at least one cyanide group containing aromatic compound according to Formula (I) and/or Formula (II) as defined in claim 1 to the electroless palladium deposition bath,
e) and thereby decreasing the deposition rate of the aqueous electroless palladium deposition bath.

18. The method for adjusting the deposition rate according to claim 17 further comprising one or more of steps
c.i) determining the deposition rate and/or the concentration of the at least one cyanide group containing aromatic compound according to Formula (I) and/or Formula (II) within the aqueous electroless palladium deposition bath according to step c);
c.ii) comparing the value for deposition rate and/or concentration of the at least one cyanide group containing aromatic compound according to Formula (I) and/or Formula (II) determined according to step c.i) with pre-set corresponding threshold values;
c.iii) determining the deviation of the value for deposition rate and/or concentration of the at least one cyanide group containing aromatic compound according to Formula (I) and/or Formula (II) from their corresponding threshold values;
c.iv) correlating the deviation determined according to step c.iii) to an amount of the at least one cyanide group containing aromatic compound according to Formula (I) and/or Formula (II) to be added to the aqueous electroless palladium deposition bath in step d).

19. Use of at least one cyanide group containing aromatic compound according to Formula (I) and/or Formula (II) as defined in claim 1 for
stabilizing any aqueous electroless palladium deposition bath composition against undesired decomposition;
expanding the life time of any aqueous electroless palladium deposition bath composition;
decreasing sensitivity of any aqueous electroless palladium deposition bath composition to contaminations; and/or
adjusting the deposition rate of any aqueous electroless palladium deposition bath.

## Patentansprüche

1. Wässrige Plattierbadzusammensetzung zum stromlosen Abscheiden von Palladium, umfassend:
(i) mindestens eine Quelle für Palladiumionen,
(ii) mindestens ein Reduktionsmittel für Palladiumionen, und
(iii)mindestens eine Cyanidgruppen enthaltende aromatische Verbindung, ausgewählt aus Verbindungen gemäß der Formel (I), Salzen davon und Mischungen der Vorgenannten; und/oder mindestens eine Cyanidgruppen enthaltende aromatische Verbindung, ausgewählt aus Verbindungen gemäß der Formel (II), Salzen davon und Mischungen der Vorgenannten; 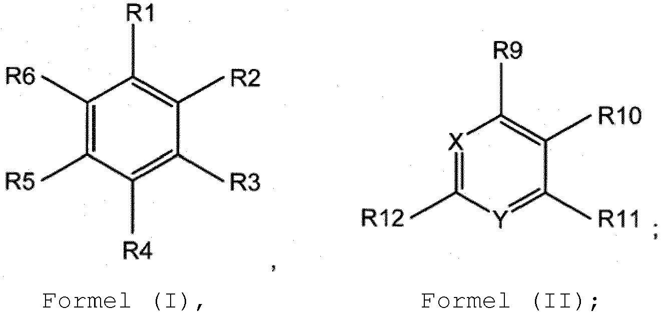 wobei R1, R2, R3, R4, R5, R6 unabhängig voneinander ausgewählt sind aus der Gruppe bestehend aus R7, - H, einer C1-C6-Alkylgruppe, einer C1-C6-Alkoxygruppe, Amino, Aldehyd, Mercapto, einer Sulfidgruppe, Halogen, Allyl, Vinyl, Ethynyl, Propynyl, 1-Butynyl, 2-Butynyl, 2-Ethynylbenzol, Phenyl, Pyridyl, und Naphtylgruppen; wobei mindestens eines von R1 bis R6 R7 ist; wobei R7 eine Gruppe gemäß der Formel (III) ist, 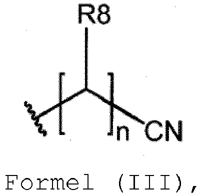
wobei jedes R8 unabhängig ausgewählt ist aus der Gruppe bestehend aus -H, einer C1-C6-Alkylgruppe, Hydroxyl, einer C1-C6-Alkoxygruppe, Amino, Mercapto, und einer Sulfidgruppe; wobei n eine ganze Zahl im Bereich von 0 bis 4 ist; und
wobei X ausgewählt ist aus N und C-R13;
wobei Y ausgewählt ist aus N und C-R14; wobei mindestens eines von X oder Y N ist;
wobei R9, R10, R11, R12, R13, R14 unabhängig voneinander ausgewählt sind aus der Gruppe bestehend aus R15, -H, einer C1-C6-Alkylgruppe, Hydroxyl, einer C1-C6-Alkoxygruppe, Amino, Aldehyd, Carboxyl, Ester, Sulfonsäure, Mercapto, einer Sulfidgruppe, Halogen, Allyl, Vinyl, Ethynyl, Propynyl, 1-Butynyl, 2-Butynyl, 2-Ethynylbenzol, Phenyl, Pyridyl, und Naphtylgruppen; wobei mindestens eines von R9 bis R14 R15 ist;
wobei R15 eine Gruppe gemäß der Formel (IV) ist, 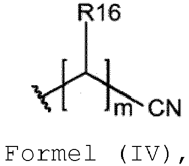
wobei jedes R16 unabhängig ausgewählt ist aus der Gruppe bestehend aus -H, einer C1-C6-Alkylgruppe, Hydroxyl, einer C1-C6-Alkoxygruppe, Amino, Mercapto, und einer Sulfidgruppe; wobei m eine ganze Zahl im Bereich von 0 bis 4 ist, und
wobei, wenn mindestens eines von X oder Y N ist, R15 in der ortho- oder meta-Stellung in Bezug auf N innerhalb des aromatischen Rings gemäß der Formel (II) ist.

2. Wässrige Plattierbadzusammensetzung nach Anspruch 1, wobei n 0 ist.

3. Wässrige Plattierbadzusammensetzung nach Anspruch 1 oder 2, wobei mindestens eines von R1 bis R6 Halogen ist.

4. Wässrige Plattierbadzusammensetzung nach einem der vorhergehenden Ansprüche, wobei mindestens eines von R1 bis R6 Halogen ist, und mindestens eines von R1 bis R6 Amino ist.

5. Wässrige Plattierbadzusammensetzung nach Anspruch 1, wobei X nicht N ist, wenn Y N ist; oder Y nicht N ist, wenn X N ist.

6. Wässrige Plattierbadzusammensetzung nach Anspruch 1 oder 5, wobei m eine ganze Zahl ist, ausgewählt aus 0 oder 1.

7. Wässrige Plattierbadzusammensetzung nach den Ansprüchen 1, 5 oder 6, wobei, wenn X nicht N ist, wenn Y N ist, oder wenn Y nicht N ist, wenn X N ist, R15 in meta-Stellung in Bezug auf N innerhalb des aromatischen Rings gemäß der Formel (II) ist.

8. Wässrige Plattierbadzusammensetzung nach einem der vorhergehenden Ansprüche, wobei die mindestens eine Cyanidgruppen enthaltende aromatische Verbindung gemäß der Formel (I) ausgewählt ist aus der Gruppe umfassend 3-Chlorbenzonitril, 4-Amino-2-chlorbenzonitril, 2-Hydroxy-2-(pyridin-3-yl)-acetonitril, 2-Amino-2-(pyridin-3-yl)-acetonitril, Picolinonitril, Nicotinonitril, Pyridin-3,5-dicarbonitril, 2-Aminopyridin-3,5-dicarbonitril und Pyrimidin-2-carbonitril.

9. Wässrige Plattierbadzusammensetzung nach einem der vorhergehenden Ansprüche, wobei die mindestens eine Cyanidgruppen enthaltende aromatische Verbindung gemäß der Formel (I) eine Konzentration im Bereich von 0,01 bis 100 mg/l aufweist.

10. Wässrige Plattierbadzusammensetzung nach einem der vorhergehenden Ansprüche, wobei der pH-Wert im Bereich von 4 bis 7 liegt.

11. Wässrige Plattierbadzusammensetzung nach einem der vorhergehenden Ansprüche, ferner umfassend mindestens ein Komplexierungsmittel für Palladiumionen, ausgewählt aus der Gruppe bestehend aus primären Aminen, sekundären Aminen und tertiären Aminen.

12. Wässrige Plattierbadzusammensetzung nach Anspruch 11, wobei das Molverhältnis von dem Komplexierungsmittel für Palladiumionen und Palladiumionen in der wässrigen Plattierbadzusammensetzung im Bereich von 0,5 : 1 bis 50 : 1 liegt.

13. Wässrige Plattierbadzusammensetzung nach einem der vorhergehenden Ansprüche, wobei das mindestens eine Reduktionsmittel für Palladiumionen ausgewählt ist aus der Gruppe umfassend hypophosphorige Säure, Aminborane, Borhydride, Hydrazin, Formaldehyd, Ameisensäure, Derivate der Vorgenannten und Salze davon.

14. Wässrige Plattierbadzusammensetzung nach einem der vorhergehenden Ansprüche, wobei die Konzentration des mindestens einen Reduktionsmittels im Bereich von 10 bis 1000 mmol/l liegt.

15. Verfahren zum stromlosen Plattieren von Palladium, umfassend die Schritte:
a) Bereitstellen eines Substrats,
b) Inberührungbringen des Substrats mit der wässrigen Plattierbadzusammensetzung nach einem der Ansprüche 1 bis 14 und dadurch Abscheiden einer Schicht aus Palladium auf mindestens einem Abschnitt des Substrats.

16. Verfahren zum stromlosen Plattieren von Palladium nach Anspruch 15, wobei das Substrat mit der wässrigen Plattierbadzusammensetzung bei einer Temperatur von 30 bis 65 °C in Schritt b) in Berührung gebracht wird.

17. Verfahren zum Einstellen der Abscheidungsrate eines beliebigen stromlosen wässrigen Palladiumabscheidungsbads, wobei das Verfahren die Schritte umfasst:
c) Bereitstellen eines beliebigen stromlosen wässrigen Palladiumabscheidungsbads, und
d) Zusetzen mindestens einer Cyanidgruppen enthaltenden aromatischen Verbindung gemäß der Formel (I) und/oder Formel (II), wie in Anspruch 1 definiert, zu dem stromlosen Palladiumabscheidungsbad,
e) und dadurch Verringern der Abscheidungsrate des stromlosen wässrigen Palladiumabscheidungsbads.

18. Verfahren zum Einstellen der Abscheidungsrate nach Anspruch 17, ferner umfassend einen oder mehrere der Schritte:
c.i) Bestimmen der Abscheidungsrate und/oder der Konzentration der mindestens einen Cyanidgruppen enthaltenden aromatischen Verbindung gemäß der Formel (I) und/oder Formel (II) innerhalb des stromlosen wässrigen Palladiumabscheidungsbads gemäß Schritt c);
c.ii) Vergleichen des Werts für die Abscheidungsrate und/oder Konzentration der mindestens einen Cyanidgruppen enthaltenden aromatischen Verbindung gemäß der Formel (I) und/oder Formel (II), die gemäß Schritt c.i) bestimmt wird, mit voreingestellten entsprechenden Schwellenwerten;
c.iii) Bestimmen der Abweichung des Werts für die Abscheidungsrate und/oder Konzentration der mindestens einen Cyanidgruppen enthaltenden aromatischen Verbindung gemäß der Formel (I) und/oder Formel (II) von ihren jeweiligen Schwellenwerten;
c.iv) Korrelieren der Abweichung, die gemäß Schritt c.iii) bestimmt wird, mit einer Menge der mindestens einen Cyanidgruppen enthaltenden aromatischen Verbindung gemäß der Formel (I) und/oder Formel (II), um dem stromlosen wässrigen Palladiumabscheidungsbad in Schritt d) zugesetzt zu werden.

19. Verwendung mindestens einer Cyanidgruppen enthaltenden aromatischen Verbindung gemäß der Formel (I) und/oder Formel (II), wie in Anspruch 1 definiert, zum:
Stabilisieren einer beliebigen stromlosen wässrigen Palladiumabscheidungsbadzusammensetzung gegen eine unerwünschte Zersetzung;
Erweitern der Lebensdauer einer beliebigen stromlosen wässrigen Palladiumabscheidungsbadzusammensetzung;
Verringern der Empfindlichkeit einer beliebigen stromlosen wässrigen Palladiumabscheidungsbadzusammensetzung für Verunreinigungen; und/oder
Einstellen der Abscheidungsrate eines beliebigen stromlosen wässrigen Palladiumabscheidungsbads.

## Revendications

1. Composition aqueuse de bain de placage pour le dépôt autocatalytique de palladium, comprenant
(i) au moins une source d'ions palladium,
(ii) au moins un réducteur d'ions palladium, et
(iii) au moins un composé aromatique contenant un groupe cyanure choisi parmi les composés répondant à la formule (I), les sels de ceux-ci, et les mélanges des composés susmentionnés ; et/ou au moins un composé aromatique contenant un groupe cyanure choisi parmi les composés répondant à la formule (II), les sels de ceux-ci, et les mélanges des composés susmentionnés, 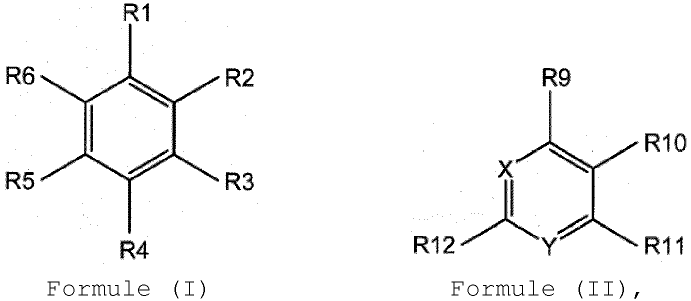 dans laquelle R1, R2, R3, R4, R5, R6 sont choisis indépendamment les uns des autres dans le groupe constitué par R7, -H, les groupes alkyle en C1 à C6, alcoxy en C1 à C6, amino, aldéhyde, mercapto, sulfure, halogéno, allyle, vinyle, éthynyle, propynyle, 1-butynyle, 2-butynyle, 2-éthynylbenzène, phényle, pyridyle, et naphtyle ; dans laquelle au moins un de R1 à R6 est R7 ;
dans laquelle R7 est un groupement répondant à la formule (III), 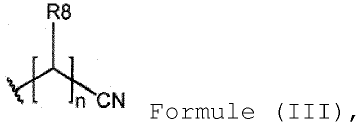
dans laquelle chaque R8 est indépendamment choisi dans le groupe constitué par -H, les groupes alkyle en C1 à C6, hydroxyle, alcoxy en C1 à C6, amino, mercapto, et sulfure ; dans laquelle n est un entier allant de 0 à 4 ; et
dans laquelle X est choisi entre N et C-R13 ;
dans laquelle Y est choisi entre N et C-R14 ; dans laquelle au moins un de X et Y est N ;
dans laquelle R9, R10, R11, R12, R13, R14 sont choisis indépendamment les uns des autres dans le groupe constitué par R15, -H, les groupes alkyle en C1 à C6, hydroxyle, alcoxy en C1 à C6, amino, aldéhyde, carboxyle, ester, acide sulfonique, mercapto, sulfure, halogéno, allyle, vinyle, éthynyle, propynyle, 1-butynyle, 2-butynyle, 2-éthynylbenzène, phényle, pyridyle, et naphtyle ; dans laquelle au moins un de R9 à R14 est R15 ;
dans laquelle R15 est un groupement répondant à la formule (IV), 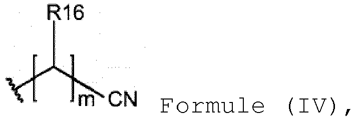
dans laquelle chaque R16 est indépendamment choisi dans le groupe constitué par -H, les groupes alkyle en C1 à C6, hydroxyle, alcoxy en C1 à C6, amino, mercapto, et sulfure ; dans laquelle m est un entier allant de 0 à 4, et
dans laquelle, si au moins un de X et Y est N, R15 est dans la position ortho ou méta par rapport à N dans le cycle aromatique répondant à la formule (II).

2. Composition aqueuse de bain de placage selon la revendication 1 dans laquelle n vaut 0.

3. Composition aqueuse de bain de placage selon la revendication 1 ou 2 dans laquelle au moins un de R1 à R6 est un halogène.

4. Composition aqueuse de bain de placage selon l'une quelconque des revendications précédentes dans laquelle au moins un de R1 à R6 est un halogène et au moins un de R1 à R6 est un amino.

5. Composition aqueuse de bain de placage selon la revendication 1 dans laquelle X n'est pas N si Y est N ; ou Y n'est pas N si X est N.

6. Composition aqueuse de bain de placage selon la revendication 1 ou 5 dans laquelle m est un entier choisi entre 0 et 1.

7. Composition aqueuse de bain de placage selon les revendications 1, 5 ou 6 dans laquelle, quand X n'est pas N si Y est N, ou quand Y n'est pas N si X est N, R15 est en position méta par rapport à N dans un cycle aromatique répondant à la formule (II).

8. Composition aqueuse de bain de placage selon l'une quelconque des revendications précédentes dans laquelle l'au moins un composé aromatique contenant un groupe cyanure répondant à la formule (I) est choisi dans le groupe comprenant le 3-chlorobenzonitrile, le 4-amino-2-chlorobenzonitrile, le 2-hydroxy-2-(pyridine-3-yl)-acétonitrile, le 2-amino-2-(pyridine-3-yl)acétonitrile, le picolinonitrile, le nicotinonitrile, le pyridine-3,5-dicarbonitrile, le 2-aminopyridine-3,5-dicarbonitrile, et le pyrimidine-2-carbonitrile.

9. Composition aqueuse de bain de placage selon l'une quelconque des revendications précédentes, dans laquelle l'au moins un composé aromatique contenant un groupe cyanure répondant à la formule (I) a une concentration allant de 0,01 à 100 mg/l.

10. Composition aqueuse de bain de placage selon l'une quelconque des revendications précédentes, dans laquelle la valeur de pH va de 4 à 7.

11. Composition aqueuse de bain de placage selon l'une quelconque des revendications précédentes, comprenant en outre au moins un complexant d'ions palladium choisi dans le groupe constitué par les amines primaires, les amines secondaires et les amines tertiaires.

12. Composition aqueuse de bain de placage selon la revendication 11, le rapport molaire entre le complexant d'ions palladium et les ions palladium dans la composition aqueuse de bain de placage allant de 0,5:1 à 50:1.

13. Composition aqueuse de bain de placage selon l'une quelconque des revendications précédentes, dans laquelle l'au moins un réducteur d'ions palladium est choisi dans le groupe comprenant l'acide hypophosphoreux, les aminoboranes, les borohydrures, l'hydrazine, le formaldéhyde, l'acide formique, les dérivés des composés susmentionnés et les sels de ceux-ci.

14. Composition aqueuse de bain de placage selon l'une quelconque des revendications précédentes, dans laquelle la concentration de l'au moins un réducteur va de 10 à 1000 mmol/l.

15. Procédé de placage autocatalytique de palladium comprenant les étapes consistant à
a) se procurer un substrat,
b) mettre le substrat en contact avec la composition aqueuse de bain de placage selon l'une quelconque des revendications 1 à 14 et déposer ainsi une couche de palladium sur au moins une partie du substrat.

16. Procédé de placage autocatalytique de palladium selon la revendication 15 dans lequel le substrat est mis en contact avec la composition aqueuse de bain de placage à une température de 30 à 65 °C à l'étape b).

17. Procédé de réglage de la vitesse de dépôt de n'importe quel bain aqueux de dépôt autocatalytique de palladium, le procédé comprenant les étapes consistant à
c) se procurer n'importe quel bain aqueux de dépôt autocatalytique de palladium, et
d) ajouter au moins un composé aromatique contenant un groupe cyanure répondant à la formule (I) et/ou la formule (II) tel que défini dans la revendication 1 au bain de dépôt autocatalytique de palladium,
e) et réduire ainsi la vitesse de dépôt du bain aqueux de dépôt autocatalytique de palladium.

18. Procédé de réglage de la vitesse de dépôt selon la revendication 17 comprenant en outre une ou plusieurs des étapes suivantes :
c.i) déterminer la vitesse de dépôt et/ou la concentration de l'au moins un composé aromatique contenant un groupe cyanure répondant à la formule (I) et/ou la formule (II) dans le bain aqueux de dépôt autocatalytique de palladium selon l'étape c) ;
c.ii) comparer la valeur de vitesse de dépôt et/ou de concentration de l'au moins un composé aromatique contenant un groupe cyanure répondant à la formule (I) et/ou la formule (II) déterminée selon l'étape c.i) à des valeurs seuils prédéfinies correspondantes ;
c.iii) déterminer l'écart entre la valeur de vitesse de dépôt et/ou de concentration de l'au moins un composé aromatique contenant un groupe cyanure répondant à la formule (I) et/ou la formule (II) et leurs valeurs seuils correspondantes ;
c.iv) corréler l'écart déterminé selon l'étape c.iii) avec une quantité de l'au moins un composé aromatique contenant un groupe cyanure répondant à la formule (I) et/ou la formule (II) à ajouter au bain aqueux de dépôt autocatalytique de palladium à l'étape d).

19. Utilisation d'au moins un composé aromatique contenant un groupe cyanure répondant à la formule (I) et/ou la formule (II) tel que défini dans la revendication 1 pour
stabiliser n'importe quelle composition aqueuse de bain de dépôt autocatalytique de palladium contre une décomposition indésirable ;
prolonger la durée de vie de n'importe quelle composition aqueuse de bain de dépôt autocatalytique de palladium ;
réduire la sensibilité de n'importe quelle composition aqueuse de bain de dépôt autocatalytique de palladium aux contaminations ; et/ou
régler la vitesse de dépôt de n'importe quel bain aqueux de dépôt autocatalytique de palladium.
